# EUROPÄISCHE PATENTSCHRIFT

(11) **EP 2 101 550 B1**
(45) Veröffentlichungstag und Bekanntmachung des Hinweises auf die Patenterteilung: **13.07.2011**
(21) Anmeldenummer: 08152756.6
(22) Anmeldetag: 14.03.2008
(51) Int. Cl.: H05K 1/05, H05K 1/18, H01L 33/00, H01L 25/075, H01L 25/16

(54) **Isoliertes Metallsubstrat mit einem metallenen Implantat**
Insulated metal substrate with a metal implant
Substrat métallique isolé avec un implant métallique

(43) Veröffentlichungstag der Anmeldung: 16.09.2009
(73) Patentinhaber: Asetronics AG, 3018 Bern 18 (CH)
(72) Erfinder: Piller, Hugo, CH-3127, Mühlethurnen (CH)
(74) Vertreter: Rutz & Partner

(56) Entgegenhaltungen:
- EP-A- 1 439 584
- EP-A- 1 635 403
- JP-A- 62 235 787
- US-A- 4 935 665
- US-A- 5 898 128
- US-A1- 2003 072 153

## Beschreibung

Die Erfindung betrifft ein isoliertes Metallsubstrat nach dem Oberbegriff des Patentanspruchs 1.

Isolierte Metallsubstrate, die beispielsweise in [1], US 5,112,668 und [2], EP 1 635 403 A1 beschrieben sind, weisen ein metallenes Substrat bzw. einen metallenen Träger auf, der in der Regel einseitig mit einer dünnen Isolationsschicht versehen ist, auf der elektrische Leiterbahnen angeordnet sind. Die Verlustleistung elektrischer Bauteile, die auf dem isolierten Metallsubstrat angeordnet und mit den elektrischen Leiterbahnen verbunden sind, wird durch die gut wärmeleitende Isolationsschicht auf das Metallsubstrat übertragen und abgeführt.

Leuchtdioden (LED's), insbesondere LED-Matrizen, die mittlerweile in verschiedenen Anwendungsbereichen (Strassenverkehrstechnik, Beleuchtung, Signalisierung) eingesetzt werden und die eine hohe spezifische Ausstrahlung, d.h. eine hohe Strahlungsleistung pro Sendefläche aufweisen, können vorteilhaft auf derartigen isolierten Metallsubstraten angeordnet werden. Die durch die Verlustleistung verursachte Wärmeenergie wird an das Metallsubstrat abgegebenen, und beispielsweise weiter an einen Kühlkörper abgeführt.

Sofern der Wärmetransfer optimiert werden soll, werden die elektrischen Bauteile direkt mit dem Metallsubstrat verbunden. Besonders vorteilhaft ist die Anordnung von Leuchtdioden in einer beispielsweise kegelförmigen Einsenkung des Metallsubstrats, die als Reflektor für die von den Leuchtdioden abgegebene Strahlung dient.

Die spezifische Ausstrahlung kann durch Erhöhung der Dichte der in einer LED-Matrix enthaltenen Leuchtdioden sowie durch Erhöhung der Strahlungsleistungen der einzelnen Leuchtdioden signifikant erhöht werden, da die bei den Bauteilen auftretende Verlustwärme zuverlässig abgeführt wird. Eine Zerstörung oder Leistungsbeeinträchtigung der in der LED-Matrix enthaltenen Leuchtdioden wird daher selbst bei sehr hohen Strahlungsleistungen vermieden.

Wie in [2] weiter beschrieben ist, wurden zur Optimierung der Eigenschaften des isolierten Metallsubstrats Metallsubstrate aus Kupfer oder mit Silizium und Magnesium versehene Aluminiumlegierungen verwendet, deren Ausdehnungskoeffizient bzw. Wärmedehnungskoeffizient im Bereich von 17 ppm/K oder darunter liegt. Dies erlaubt die Montage bzw. das Verlöten von Keramikbauteilen auf der Oberfläche des isolierten Metallsubstrats 1, ohne dass anschliessend beim Durchlaufen von Temperaturgradienten, aufgrund von Wärmedehnungen, Brüche der Lötstellen oder des Keramikkörpers auftreten.

In der Praxis wurden trotz der oben beschriebenen Massnahmen jedoch immer wieder Ausfälle von elektrischen und elektronischen Bauteilen beobachtet, die unterhalb der zu erwartenden Lebensdauer dieser Bauteile auftraten.

Aus der Patentschrift US 5 898 128 ist bekannt, dass bei der Verwendung von Metallsubstraten Probleme mit der Zuverlässigkeit der montierten elektronischen Komponenten auftreten können. Weiterhin ist ausgeführt, dass die Verwendung von Metallsubstraten kostenintensiv ist. In der US 5 898 128 wird für die Realisierung von elektronischen Modulen daher die Verwendung von isolierenden Substraten empfohlen.

Der vorliegenden Erfindung liegt daher die Aufgabe zugrunde, isolierte Metallsubstrate weiter zu verbessern.

Insbesondere sind die isolierten Metallsubstrate derart zu verbessern, dass die Häufigkeit von Ausfällen elektrischer Bauteile, die auf diesen isolierten Metallsubstraten montiert werden, signifikant reduziert wird. Ferner sollen insbesondere hochintegrierte Bauteile auf beiden Seiten des isolierten Metallsubstrats angeordnet werden können. Weiterhin sollen sperrige Anschlusselemente an beliebigen Stellen stabil montiert werden können.

Die Lösung dieser Aufgabe gelingt mit einem isolierten Metallsubstrat nach dem Patentanspruch 1. Die Lösung dieser Aufgabe gelingt mit einem isolierten Metallsubstrat nach dem Oberbegriff des Patentanspruchs 1.

Vorteilhafte Ausgestaltungen dieser Erfindung sind in den weiteren Ansprüchen angegeben.

Das isolierte Metallsubstrat weist ein Metallsubstrat auf, zumindest an dessen Oberseite eine Isolationsschicht mit darüber liegenden elektrischen Bahnen angeordnet ist, an die wenigstens ein elektrisches Bauteil anschliessbar ist.

Erfindungsgemäss ist das Metallsubstrat mit wenigstens einer Ausnehmung versehen, in die ein metallenes Implantat eingesetzt ist, dessen Abmessungen zumindest annähernd den Abmessungen der Ausnehmung entsprechen und das der Montage wenigstens eines elektrischen Bauteils dient. Auf diese Weise gelingt es, das isolierte Metallsubstrat optimal an die Erfordernisse des Anwenders und die Eigenschaften der zu montierenden Bauteile anzupassen.

Wie eingangs beschrieben, wird durch das Metallsubstrat die Verlustwärme der montierten elektronischen und elektrischen Bauteile effizient abgeführt. Thermische Probleme werden durch die Wahl eines isolierten Metallsubstrats beispielsweise eines für Leiterplatten verwendeten Materials weitgehend vermieden. Durch den effizienten Transfer der erzeugten Wärmeenergie hin zu einer Wärmesenke bleibt die Temperatur im Bereich elektrischer und elektronischer Bauteile daher weitgehend konstant. Durch die geeignete Wahl des Metallsubstrats können die bei relativ tiefen Temperaturschwankungen auftretenden geringen Wärmedehnungen zudem weitgehend vermieden werden.

Bei Hochleistungselementen, beispielsweise Leuchtdioden mit extrem hoher Strahlungsintensität hat sich hingegen herausgestellt, dass die bekannten Massnahmen Ausfälle insbesondere solcher Elemente nicht im erwünschten Mass verhindern konnten, wobei die Ursachen der Ausfälle jedoch kaum je präzise ermittelt werden konnten.

Durch den Einbau eines Metallimplantats in das Metallsubstrat konnte die Fehlerhäufigkeit insbesondere bei leistungsstarken Bauteilen signifikant reduziert werden. Dabei werden Metallimplantate gewählt, deren Dehnungskoeffizienten etwa denjenigen der Baumaterialien der elektronischen Bauteile entsprechen. Vorzugsweise werden Metallimplantate mit einem Dehnungskoeffizienten gewählt, der den Ausdehnungskoeffizienten keramischer Materialien, wie A1203, BeO, AlN, AlSiCl2, ähnlich ist, die für den Aufbau integrierter Schaltungen verwendet werden.

Vorzugsweise wird ein Metallimplantat aus Kupfer oder einer Legierung, insbesondere einer Invar-Legierung, gewählt, die im Bereich der Betriebstemperaturen einen Ausdehnungskoeffizienten von 5 ppm/K bis 12 ppm/K aufweist. Beispielsweise werden Eisenlegierungen, wie FeNi, FePt, FePd, FeMn, CoMn, FeNiPt, FeNiMn, CoMnFe oder Kupferlegierungen, wie WCu, MoCu gewählt. Regelmässig sind Legierungen geeignet, die einen hohen Anteil an Wolfram oder Molybdän aufweisen.

Besonders vorteilhaft, sind auch isolierende Implantate einsetzbar, die beispielsweise aus einem konventionellen Leiterplattenmaterial bestehen. Vorteilhaft sind faserverstärkte Materialien, wie FR-2, F3 oder FR4, verwendbar, die mit einem Reaktionsharz aus Phenol oder Epoxy gefertigt werden. Insbesondere von Vorteil ist, dass innerhalb des isolierten Metallsubstrats Zonen geschaffen werden, die nicht der Wärmedehnung des Metallsubstrats unterworfen sind und die gleichzeitig zusätzliche, vorteilhafte Montagemöglichkeiten bieten. Beispielsweise kann das isolierte Metallsubstrat beidseitig bestückt und mit elektrischen Komponenten versehen werden, die beispielsweise dem Anschluss eines Kabels oder Steckverbinders dienen und die auf einem konventionellen isolierten Metallsubstrat weniger vorteilhaft montiert werden könnten.

Das isolierende Implantat kann einseitig oder beidseitig mit Elementen einer leitenden Metallschicht, beispielsweise einer Kupferschicht, versehen sein, die vorzugsweise ebenfalls die Leiterbahnen auf dem isolierten Metallsubstrat bildet. Beispielsweise sind auf beiden Seiten des isolierenden Implantats Leiterbahnen vorgesehen, die dem Anschluss elektrischer oder elektronischer Bauteile dienen. Ferner können Elemente der Metallschicht auch als thermische Brücken dienen, welche thermische Energie vom isolierenden Implantat ableitet.

Die Abmessungen des isolierenden Implantats sind vorzugsweise derart gewählt, dass dieses in eine Öffnung der Isolationsschicht derart hineinragt, dass das isolierende Implantat und die Isolationsschicht eine praktisch ebene Oberfläche bilden.

Das metallene Implantat und/oder das isolierende Implantat können einseitig oder beidseitig von der Isolationsschicht auch teilweise, vorzugsweise rahmenartig, überlappt und dadurch gehalten werden. Auf diese Weise lassen sich Implantate leicht montieren und fixieren.

Das metallene Implantat und/oder das isolierende Implantat können auch mit Öffnungen versehen sein, durch die hindurch Kontaktierungen, so genannte Vias, oder auch isolierte elektrische Leiter geführt werden können, um zusätzliche Funktionen zu realisieren oder die Stromversorgung und Kommunikation zwischen beiden Seiten des Implantats und/oder des isolierten Metallsubstrats sicherzustellen.

Das isolierte Metallsubstrat kann daher auch beidseitig mit einer Isolationsschicht und einer Metallschicht versehen sein.

Ein isoliertes Metallsubstrat kann metallene und/oder isolierende Implantate beliebiger Form und Anzahl aufweisen. Besonders vorteilhaft können Implantate auch in flexiblen isolierten Metallsubstraten verwendet werden, um deren Eigenschaften lokal an die Anforderungen des Anwenders anzupassen.

Die Implantate können auf verschiedene Arten gefertigt und in die Ausnehmungen eingesetzt werden. Die Metallimplantate können ausgestanzt, gefräst oder erodiert und in die im Metallsubstrat vorgesehenen Ausnehmungen eingesetzt, beispielsweise eingepresst werden. Die entsprechenden Ausnehmungen können in das Metallsubstrat eingefräst oder eingestanzt werden. Durch das Einpressen in die Ausnehmungen resultiert eine enge Verbindung zwischen dem Metallimplantat und dem Metallsubstrat und somit ein praktisch vernachlässigbarer Wärmeübergangswiderstand. Auf diese Weise werden der Vorteil des optimalen Wärmetransfers und der Vorteile der Anpassung des Dehnungskoeffizienten des Substrats an die Dehnungskoeffizienten der auf dem Substrat montierten Materialien erzielt. Ferner kann das metallene Implantat, zumindest in den Zonen, in denen ein Kontakt mit dem Metallsubstrat resultiert, mit einer Schicht aus Edelmetall, wie Gold oder Silber überzogen werden. Dadurch wird dauerhaft eine optimale Verbindung erzielt und das Implantat gegen schädigende Einwirkungen geschützt.

Besonders vorteilhaft können daher elektrische oder elektronische Bauteile, wie Hochleistungs-Halbleiter mit hohen Verlustleistungen, auf den Metallimplantaten montiert werden. Insbesondere werden erfindungsgemässe isolierte Metallsubstrate auch zukünftigen Entwicklungen gerecht, die zweifellos noch leistungsfähigere Bauteile hervorbringen werden.

Die Erfindung wird nachstehend anhand von Zeichnungen näher erläutert. Dabei zeigt in Schnittdarstellung:
- Fig. 1: ein bekanntes isoliertes Metallsubstrat 100, bestehend aus einem Metallsubstrat 12, auf der, getrennt durch eine Isolationsschicht 11, Leiterbahnen einer Kupferschicht 10 angeordnet sind, welche mit einem LED-Chip 2 verbunden sind, der mittels eines wärmeleitenden Montageelements 13 mit dem Metallsubstrat 12 thermisch gekoppelt ist;
- Fig. 2: ein weiteres bekanntes isoliertes Metallsubstrat 100 mit einem Metallsubstrat 12, welches eine Einsenkung 121 aufweist, innerhalb der ein auf einem thermisch gut leitenden Montageelement 13 ruhender LED-Chip 2 angeordnet ist;
- Fig. 3: ein erfindungsgemässes isoliertes Metallsubstrat 1, in dessen Metallsubstrat 12 ein metallenes Implantat 124 eingesetzt ist, auf dem ein LED-Chip 2 angeordnet ist;
- Fig. 4: ein erfindungsgemässes isoliertes Metallsubstrat 1, in dessen Metallsubstrat 12 ein Metallimplantat 124 eingesetzt ist, das eine Einsenkung 1241 aufweist, innerhalb der ein LED-Chip 2 angeordnet ist;
- Fig. 5: einen Schnitt durch ein erfindungsgemässes isoliertes Metallsubstrat 1, in das ein metallenes Implantat 124 sowie zwei aus isolierenden Materialien bestehende Implantate 125 eingesetzt sind;
- Fig. 6: das isolierte Metallsubstrat 1 von Figur 5 von unten gesehen;
- Fig. 7: Schritte zur Fertigung von isolierten Metallsubstraten 1 gemäss Figur 5; und
- Fig. 8: Schritte zur Fertigung von vorzugsweise ausgestalteten isolierten Metallsubstraten 1 gemäss Figur 5.

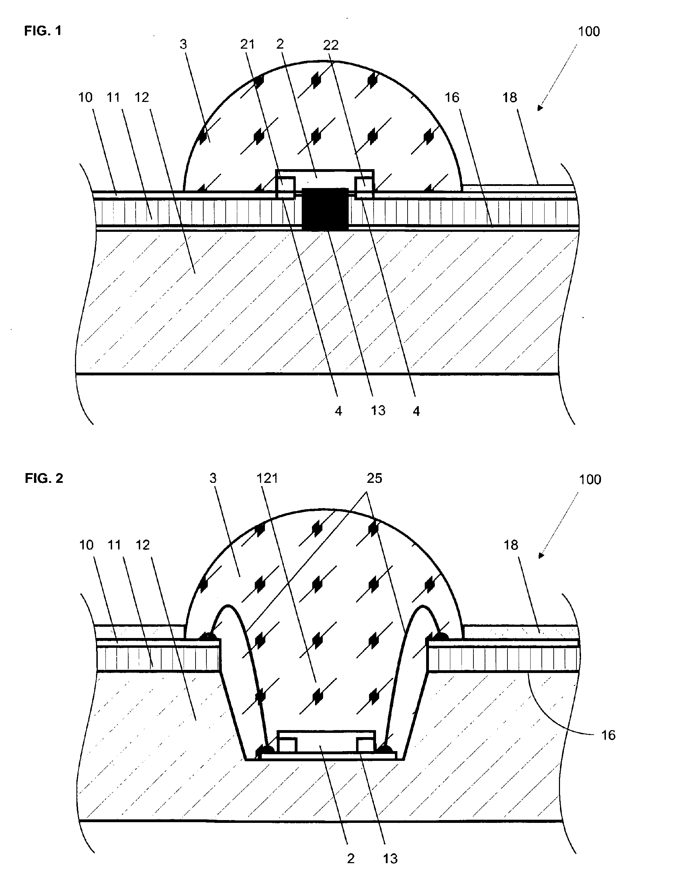

Figur 1 zeigt eine beispielsweise aus [1] bekannte Anordnung eines LED-Chips 2 auf einem isolierten Metallsubstrat 100. Das isolierte Metallsubstrat 100 besteht aus einem Metallsubstrat 12, einer dielektrischen Isolationsschicht 11 und auf der Isolationsschicht 11 vorgesehenen elektrischen Leiterbahnen 10, an die ein auf einem wärmeleitenden Element 13 ruhender LED-Chip 2 angeschlossen ist. Gezeigt sind ferner die mittels eines Lötmittels 4 verbundenen elektrischen Anschlusskontakte 21, 22 des LED-Chips 2 sowie eine Lackmaske 18, die als Löt und Oberflächenschutz dient. Weiter gezeigt ist eine Haftschicht 16, die dem Halten der Isolationsschicht 11 dient. Die vom LED-Chip 2 abgegebene thermische Energie wird mittels des wärmeleitenden Elements 13 vom LED-Chip 2 zum Metallsubstrat 12 transferiert. Zur Beeinflussung der Abstrahlung des LED-Chips 2 ist ferner eine beispielsweise aus Giessharz gefertigte Linse 3 vorgesehen. Die genannten Elemente können auch bei den erfindungsgemässen isolierten Metallsubstraten entsprechend verwendet werden.

Figur 2 zeigt ein weiteres bekanntes isoliertes Metallsubstrat 100 mit einem Metallsubstrat 12, welches eine Einsenkung 121 aufweist, innerhalb der ein auf einem thermisch gut leitenden Montageelement 20 ruhender LED-Chip 2 angeordnet ist, der über Anschlussleitungen 25 mit den elektrischen Leiterbahnen 10 verbunden ist.

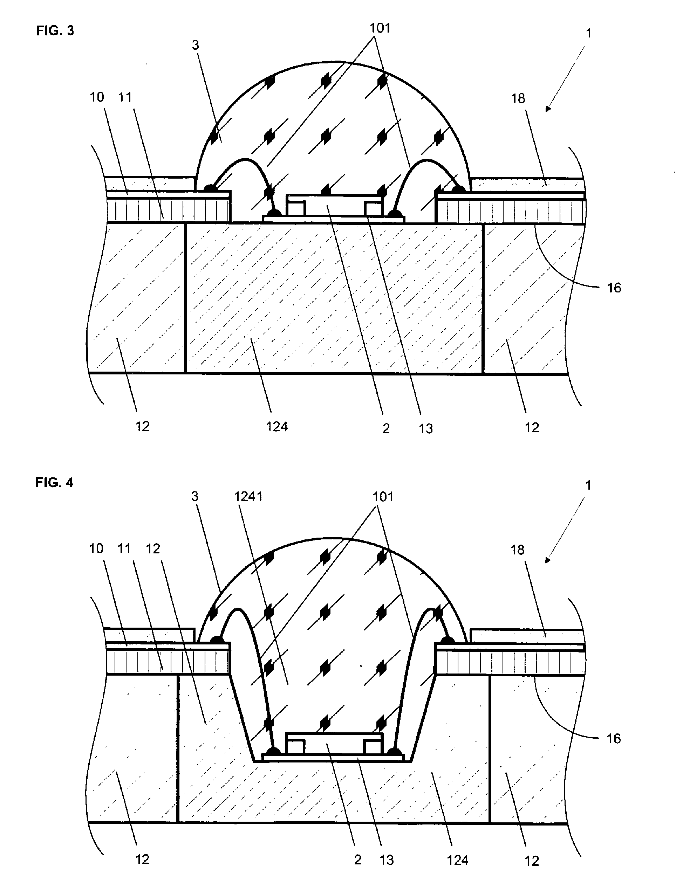

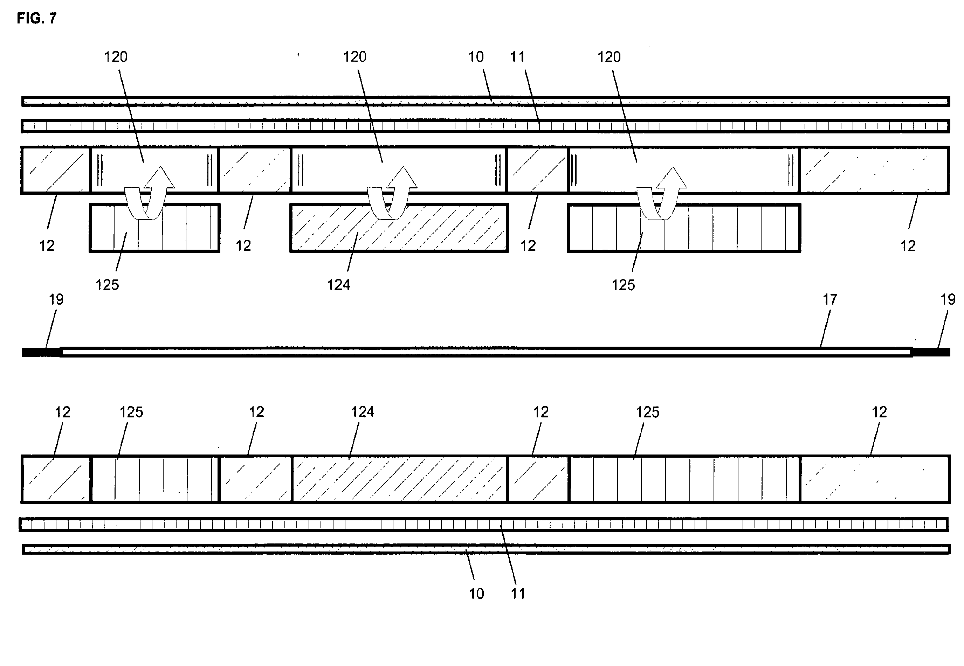

Figur 3 zeigt ein erfindungsgemässes isoliertes Metallsubstrat 1, in dessen Metallsubstrat 12 ein metallenes Implantat 124 eingesetzt ist, auf dem ein LED-Chip 2 angeordnet ist. Wie dies in Figur 7 gezeigt ist, wird dazu im Metallsubstrat 12 eine Ausnehmung 120 vorgesehen, in die ein der Ausnehmung 120 entsprechendes Implantat 124 eingesetzt wird. Die vorzugsweise gefräste oder gestanzte Ausnehmung 120 und das Implantat 124 werden vom Anwender entsprechend der Architektur des Schaltungsaufbaus gewählt und können beliebige Querschnitte aufweisen. Beispielsweise werden runde bzw. zylinderförmige Ausnehmungen vorgesehen, in die zylinderförmige Implantate 124 eingesetzt werden. Wie in Figur 3 gezeigt, bilden die Implantate 124 zusammen mit dem Metallsubstrat 12 vorzugsweise auf beiden Seiten eine ebene Oberfläche. Das Implantat 124 wird vorzugsweise mit präzisen Abmessungen gefertigt, beispielsweise aus einer entsprechenden Metallplatte gestanzt oder durch Funkenerosion ausgeschnitten. Das Implantat 124 kann daher nahtlos in das Metallsubstrat 12 eingepresst werden, so dass eine optimale thermische Verbindung resultiert. Weitere Möglichkeiten zur Verbindung des Implantats 124 mit dem Metallsubstrat 12 sind Schweiss- oder Lötverfahren sowie die Anwendung thermisch guter leitender Klebstoffe.

In Figur 3 ist der LED-Chip 2 auf ein wärmeleitendes Montageelement 13 aufgesetzt, auf dem Anschlusskontakte für Anschlussleitungen 101 vorgesehen sind, mittels derer der LED-Chip 2 mit den Leiterbahnen 10 des isolierten Metallsubstrats 1 verbunden ist. Die Verlustwärme des LED-Chips 2 wird durch das wärmeleitende Montageelement 13 hindurch an das metallene Implantat 124 und somit an das Metallsubstrat 12 abgegeben.

Wie oben beschrieben wurde, werden für das metallene Metallimplantat 124 Materialien verwendet, deren Dehnungskoeffizienten den Dehnungskoeffizienten der für die elektrischen und elektronischen Bauteile verwendeten Materialien entsprechen. Wie erwähnt, sollen die Dehnungskoeffizienten im Bereich der Betriebstemperaturen vorzugsweise im Bereich von 5 ppm/K bis 12 ppm/K liegen, falls für die elektrischen und elektronischen Bauteile 2, 200 keramische Substrate eingesetzt werden. Vorteilhaft einsetzbare Materialien, insbesondere Metalllegierungen wie INVAR-Legierungen wurden oben genannt.

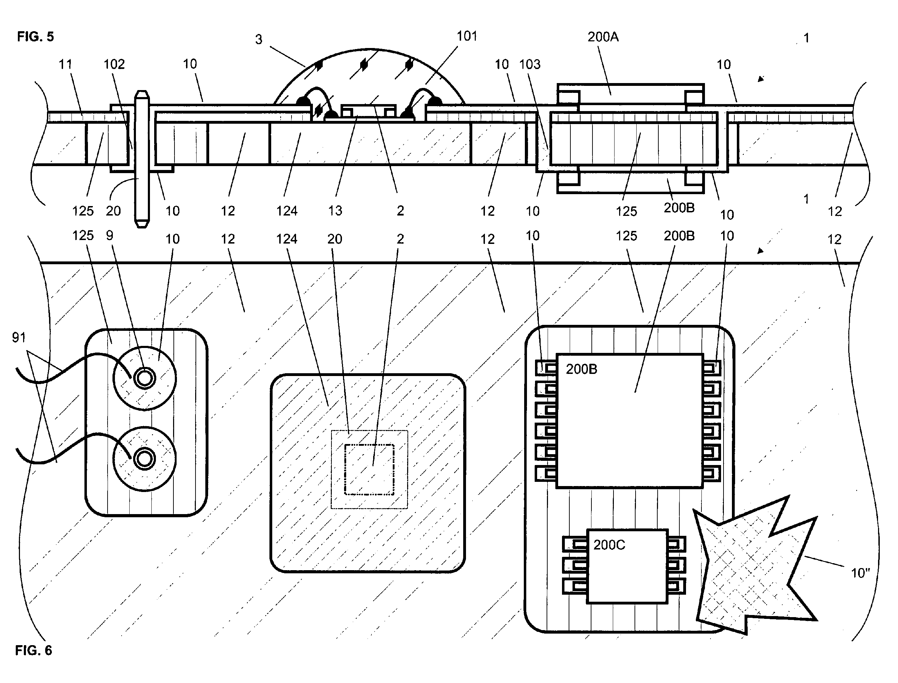

Figur 4 zeigt Ein erfindungsgemässes isoliertes Metallsubstrat 1, in dessen Metallsubstrat 12 ein zylinderförmiges Metallimplantat 124 eingesetzt ist, das eine Einsenkung 1241 aufweist, innerhalb der ein LED-Chip 2 angeordnet ist. Figur 4 offenbart daher einen weiteren Vorteil der erfindungsgemässen Lösung. Die eingesetzten metallenen Implantate 124 sowie die nachstehend vorgestellten isolierenden Implantate 125 (siehe Figur 5) können daher beliebig bearbeitet und an die zu montierenden Bauteile angepasst werden. Dabei können Formen geschaffen werden, die bei konventionellen isolierten Metallsubstraten 100 kaum realisierbar sind.

In vorzugsweisen Ausgestaltungen können auch Implantate 124, 125 eingesetzt werden, die bereits bestückt sind. Der Anwender kann daher optimal aneinander angepasste Komponenten als Module zukaufen und einsetzen. In diesem Fall ist es Sache des Anbieters, das Material des Implantats optimal an die darauf vorgesehenen Bauteile anzupassen. Da der Anbieter der elektrischen oder elektronischen Bauteile deren Eigenschaften kennt, kann er ein optimal dazu passendes Implantat wählen. Beispielsweise kann auch eine passende Linse 3 bereits aufgesetzt werden. Sofern bestückte Implantate in grossen Stückzahlen gefertigt werden, lohnt sich auch die Durchführung entsprechender Testreihen, um die Qualität zu sichern. Sofern sich die Anbieter der elektronischen Bauteile und der Anwender, welcher diese in isolierten Metallsubstraten einsetzt, sich auf einheitliche Abmessungen der Implantate einigen, wird die Lieferung von bestückten Implantaten aufgrund der zahlreichen Vorteile zweifellos rasch an Bedeutung gewinnen.

Figur 5 zeigt einen Schnitt durch ein erfindungsgemässes isoliertes Metallsubstrat 1, in das ein metallenes Implantat 124 sowie zwei aus isolierenden Materialien bestehende Implantate 125 eingesetzt sind. Der Aufbau und die Bestückung des metallenen Implantats 124 wurde mit Bezug zu Figur 3 beschriebenen, weshalb nachstehend nur noch auf die isolierenden Implantate 125 näher eingegangen wird. Wie oben erläutert, bestehen die isolierenden Implantate 125 vorzugsweise aus einem konventionellen Leiterplattenmaterial, wie FR-2, F3 oder FR4. selbstverständlich sind auch andere Materialien einsetzbar.

Wie in Figur 5 gezeigt, können die isolierenden Implantate 125 beliebig bestückt und bearbeitet werden. In den isolierenden Implantaten 125 können Steckverbinder 20 stabil verankert werden, wie dies auf der linken Seite von Figur 5 gezeigt ist. Dabei ist eine hülsenförmige, einen Kontaktstift 20 umschliessende Kontaktierung 102 vorgesehen, die durch das isolierende Implantat 125 hindurchgeführt ist. Der Kontaktstift 20 kann daher an beliebiger Stelle des isolierten Metallsubstrats 1 vorgesehen und stabil montiert werden. Im Figur 5 rechts ist gezeigt, dass ein isolierendes Implantat 125 auch beidseitig mit elektronischen Bauteilen 200A, 200B, 200C bestückt und dazu auch mit Durchkontaktierungen 103 versehen werden kann, die der Stromversorgung oder dem Signaltransfer dienen. Sofern die Verlustleistungen der elektronischen Bauteile 200A, 200B, 200C gering sind, so ist deren Montage auf isolierenden Implantaten 125 besonders vorteilhaft. Einerseits können die isolierenden Implantate 125 in konventioneller Weise mit elektronischen Bauteilen bestückt werden. Andererseits unterliegen diese elektronischen Bauteile nicht den Veränderungen des Metallsubstrats 12, welches thermischen Einflüssen unterworfen ist.

Mit dieser Technologie können daher Steuerschaltungen 200 und Treiberschaltungen nahe an Hochleistungs-Halbleitern 2 montiert werden, um diese zu steuern. Durch den Einsatz der metallenen und isolierenden Implantate 124, 125 gelingt es dabei, sowohl die Steuerschaltungen 200, als auch die Hochleistungs-Halbleiter 2 optimal zu betreiben. Gleichzeitig resultiert eine thermische Entkopplung zwischen den Hochleistungs-Halbleitern 2 und den hochintegrierten elektronischen Modulen 200A, 200B, 200C, so dass störende Wechselwirkungen vermieden werden.

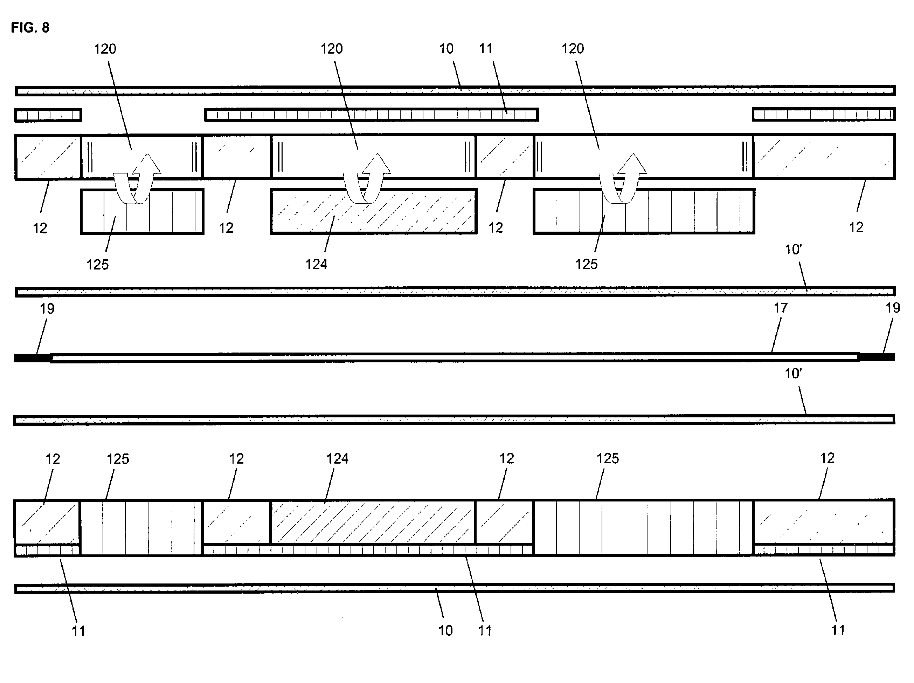

Die erfindungsgemässen isolierten Metallsubstrate, wie sie oben beschrieben wurden, werden beispielsweise, wie nachstehend mit Bezug auf die Figuren 7 und 8 beschrieben, zuerst gefertigt und dann bestückt. Es kann jedoch äusserst vorteilhaft sein, die isolierenden Implantate 125 ebenfalls bereits vor dem Einsetzen in das Metallsubstrat 12 zu bearbeiten und zu bestücken. Unabhängig vom Zeitpunkt der Bestückung können diskrete Bauelemente, wie Schalter, Kontakte, Widerstände, Kondensatoren, Dioden, Transistoren, Leuchtdioden sowie integrierte Bausteine, wie LED-Chips, Prozessoren, Speicherbausteine, Ein-Chip-Computer, Treiberschaltungen, etc., in beliebiger Zahl und Form mit den metallenen und/oder isolierenden Implantaten 124, 125 verbunden. Ferner können diskrete oder integrierte Bausteine auch ausserhalb der Implantate 124, 125 auf dem integrierten Metallsubstrat 1 angeordnet werden.

Figur 6 zeigt die Unterseite des isolierten Metallsubstrats 1 von Figur 5. Während das metallene Implantat 124 mit dem Metallsubstrat 12 eine ebene Oberfläche bildet, überragen der Steckverbinder 20 und die elektronischen Bauteile 200B, 200C diese Oberfläche. Ferner ist gezeigt, dass das isolierende Implantat 125 und das Metallsubstrat 12 auch von einer Metallschicht 10" überdeckt sein können, welche dem Wärmetransfer dient oder vorteilhafte elektrische Eigenschaften aufweist.

Figur 7 zeigt Schritte zur Fertigung von erfindungsgemässen isolierten Metallsubstraten 1 gemäss Figur 5. Es ist gezeigt, dass zwei isolierte Metallsubstrate 1 gemeinsam gefertigt werden können. Dazu werden zwei Metallsubstrate 12, durch eine Folie 17 voneinander getrennt, Rücken an Rücken aneinander gelegt. Zuvor werden in die darin vorgesehenen Ausnehmungen 120 die metallenen und isolierenden Implantate 124, 125 eingesetzt. Ferner werden auf den freiliegenden Seiten der Metallsubstrate 12 je eine Isolationsschicht 11 und eine Metallfolie 12 vorgesehen. Beispielsweise werden Metallsubstrate aus Aluminium oder Kupfer, Isolationsschichten aus Prepreg (Prepreg bezeichnet ein Halbzeug, bestehend aus Endlosfasern und einer ungehärteten duroplastischen Kunststoffmatrix) sowie Metallfolien aus Kupfer verwendet. Die Trennfolie 17 besteht aus einem Kunststoff und ist von einem Rahmen umschlossen. Das resultierende Laminat wird vorzugsweise unter Vakuum derart verpresst und dicht verklebt, dass innerhalb des Laminats ein Vakuum erhalten bleibt, welches das durch den äusseren atmosphärischen Druck zusammengepresste Laminat stabilisiert und verhindert, dass darin, beispielsweise durch Temperaturdehnungen verursacht, Wölbungen in den Laminatschichten entstehen. Die resultierenden Laminate lassen sich in den weiteren Prozessschritten problemlos erfassen, transportieren und präzise bearbeiten. An den Dichtungsrändern, in denen das Dichtungsmaterial von den Isolations- und Metallschichten überlappt wird, können zudem Index- und Fabrikationsbohrungen vorgesehen werden, welche die Durchführung nachfolgender Fabrikationsprozesse erleichtern. Nach Abschluss des Fertigungsprozesses werden die Leitplatten vereinzelt, wodurch das zuvor erzeugte Vakuum aufgehoben wird.

Figur 8 zeigt Schritte zur Fertigung von vorzugsweise ausgestalteten isolierten Metallsubstraten 1 gemäss Figur 5. Dabei sind zwischen der Trennfolie 17 und den Metallsubstraten 12 zusätzliche Metallfolien 10', beispielsweise Kupferfolien, vorgesehen, die auf den isolierenden Implantaten 125 dazu dienen, elektrische Leiterbahnen vorzusehen. Ferner ist gezeigt, dass die isolierenden Implantate 125 von der Isolationsschicht 11 nicht überdeckt werden, sondern in diese hinein ragen. Dies ist in den Fällen von Vorteil, in denen die isolierenden Implantate 125 bereits vorgearbeitet sind.

Die erfindungsgemässen isolierten Metallsubstrate 1 wurden in bevorzugten Ausgestaltungen beschrieben und dargestellt. Anhand der erfindungsgemässen Lehre sind jedoch weitere fachmännische Ausgestaltungen realisierbar. Insbesondere wird der Fachmann ausgehend von der erfindungsgemässen Lösung für jedes der beschriebenen Elemente je nach Anforderungen das passende Material zu dessen Herstellung wählen.

### Literaturverzeichnis

[1] US 5,112,668
[2] EP 1 635 403 A1

## Patentansprüche

1. Isoliertes Metallsubstrat (1) mit einem Metallsubstrat (12), an dessen Oberseite eine Isolationsschicht (11) mit elektrischen Bahnen (10) angeordnet ist, an die wenigstens ein elektrisches Bauteil (2, 20, 200) angeschlossen oder anschliessbar ist, **dadurch gekennzeichnet, dass** das Metallsubstrat (12) mit wenigstens einer Ausnehmung (120) versehen ist, in die ein metallenes Implantat (124, 125) eingesetzt ist, dessen Abmessungen zumindest annähernd denjenigen der Ausnehmung (120) entsprechen und das der Montage wenigstens eines elektrischen Bauteils (2, 20, 200) dient.

2. Isoliertes Metallsubstrat (1) nach Anspruch 1, **dadurch gekennzeichnet, dass** das gegebenenfalls mit einer Vertiefung (121) versehene metallene Implantat (124) aus einem Körper ausgestanzt, erodiert oder mittels zeine Werkzeugs ausgearbeitet und in die Ausnehmung (120) eingepasst ist und aus einem Material besteht, welches ähnliche Ausdehnungskoeffizienten wie keramische Materialien, insbesondere wie Al2O3, BeO, AlN, AlSiCl2 aufweist.

3. Isoliertes Metallsubstrat (1) nach Anspruch 2, **dadurch gekennzeichnet, dass** das wenigstens eine, gegebenenfalls mit einer Edelmetallschicht versehene metallene Implantat (124) aus Kupfer oder einer Legierung, insbesondere, einer Invar-Legierung, besteht, die im Bereich der Betriebstemperaturen einen Ausdehnungskoeffizienten von 5 ppm/K bis' 12 ppm/K aufweist, wie Eisenlegierungen, FeNi, FePt, FePd, FeMn, CoMn, FeNiPt, FeNiMn, CoMnFe oder Kupferlegierungen WCu, MoCu.

4. Isoliertes Metallsubstrat (1) nach Anspruch 1, 2 oder 3, **dadurch gekennzeichnet, dass** das wenigstens eine isolierende Implantat (125) aus einem Leiterplattenmaterial besteht, wie einem faserverstärkten Material mit einem Reaktionsharz aus Phenol oder Epoxy, wie FR-2, F3 oder FR4 und in die Ausnehmung eingepasst, gegebenenfalls ein geklebt ist.

5. Isoliertes Metallsubstrat (1) nach einem der Ansprüche 1 bis 4, **dadurch gekennzeichnet, dass** das wenigstens eine isolierende Implantat (125) von der Isolationsschicht (11) nicht überdeckt ist, und vorzugsweise derart in dieser hineinragt, dass das isolierende Implantat (125) und die Isolationsschicht (11) eine praktisch ebene Oberfläche bilden.

6. Isoliertes Metallsubstrat (1) nach einem der Ansprüche 1 bis 5, **dadurch gekennzeichnet, dass** auf dem wenigstens einen metallenen Implantat (124) wenigstens ein diskretes oder integriertes elektrisches oder elektronisches Bauteil (2), wie eine Leuchtdioden oder ein LED-Chip, montiert ist, welches eine hohe Verlustleistung aufweist und/oder dass auf dem wenigstens einen isolierenden Implantat (125) einseitig oder beidseitig wenigstens ein diskretes oder integriertes elektronisches Bauteil, wie eine integrierte Schaltung (200A; 200B, 200C) und/oder ein Anschlusskontakt (20) angeordnet ist.

7. Isoliertes Metallsubstrat (1) einem der Ansprüche 1 bis 6, **dadurch gekennzeichnet, dass** das metallene Implantat (124) und/oder das isolierende Implantat (125) vor dem Einsetzen in das Metallsubstrat (12) vorbearbeitet, insbesondere mit einer gewünschten Form versehen und/oder vorbestückt ist.

8. Isoliertes Metallsubstrat (1) nach einem der Ansprüche 1 bis 7, **dadurch gekennzeichnet, dass** das wenigstens eine isolierende Implantat (125) einseitig oder beidseitig mit Elementen der Kupferschicht (10), wie Leiterbahnen oder thermischen Brücken versehen ist, mittels derer die Abwärme des auf dem isolierenden Implantat (125) vorgesehenen elektronischen Bauteils (200A; 200B, 200C) auf das Metallsubstrat (12) übertragbar ist.

9. Isoliertes Metallsubstrat (1) nach einem der Ansprüche 1 bis 8, **dadurch gekennzeichnet, dass** das wenigstens eine metallene Implantat (124) und/oder das wenigstens eine isolierende Implantat (125) wenigstens eine Öffnung aufweist durch die hindurch ein gegebenenfalls isolierter elektrischer Leiter (10) geführt ist.

10. Isoliertes Metallsubstrat (1) nach einem der Ansprüche 1 bis 9, **dadurch gekennzeichnet, dass** das wenigstens eine metallene Implantat (124) und/oder das wenigstens eine isolierende Implantat (125) einseitig oder beidseitig von der Isolationsschicht teilweise, vorzugsweise rahmenartig überlappt wird.

## Claims

1. Insulated metal substrate (1) with a metal substrate (12), on whose upper side an insulation layer (11) with electrical tracks (10) is arranged that are connected to at least one electrical component (2, 20, 200), **characterised in that** the metal substrate (12) is provided with at least one recess (120), into which a metal implant (124, 125) is inserted, whose dimensions correspond at least approximately to those of the recess (120) and which is used for the installation of at least one electrical component (2 , 20, 200).

2. Insulated metal substrate (1) according to claim 1, **characterised in that** the metal implant (124), which optionally is provided with a indentation, is punched out of a body, eroded or worked out by means of a tool and is fitted into the recess (120) and consists of a material, which comprises similar coefficients of expansion as ceramic materials, such as Al2O3, BeO, AlN, has AlSiCl2.

3. Insulated metal substrate (1) according to claim 2, **characterised in that** the at least one metal implant (124), that is optionally coated with a layer of precious metal, consists of copper or an alloy, especially an Invar alloy, which comprises in the range of the operating temperatures an expansion coefficient of 5 ppm/K to 12 ppm/K, such as iron alloys, FeNi, FePt, FePd, FeMn, CoMn, FeNiPt, FeNiMn, or copper alloys CoMnFe WCu, MoCu.

4. Insulated metal substrate (1) according to claim 1, 2 or 3, **characterised in that** the at least one insulating implant (125) consists of a printed circuit board material such as a fiber-reinforced material with a reaction resin made from phenol or epoxy, such as FR-2, F3 or FR4 and is fitted, optionally glued, into the recess.

5. Insulated metal substrate (1) according to one of the claims 1 to 4, **characterised in that** the at least one insulating implant (125) is not covered by the insulation layer (11) and is preferably extending into it in such a way, that the insulating implant (125) and the insulation layer (11) form practically an even surface.

6. Insulated metal substrate (1) according to one of the claims 1 to 5, **characterised in that** on the at least one metal implant (124) at least one discrete or electronic component (2), such as a light emitting diode or an LED-Chip, is mounted, which comprises a high dissipation loss, and/or that on the at least one insulating implant (125) on one side or on both sides at least one discrete or integrated electronic component, such as an integrated circuit (200A; 200B, 200C) and/or a terminal (20) is arranged.

7. Insulated metal substrate (1) according to one of the claims 1 to 6, **characterised in that** the metal implant (124) an/or the insulating implant (125) are preprocessed, preferably provided with a desirable form, an/or pre-equipped before insertion into the metal substrate (12).

8. Insulated metal substrate (1) according to one of the claims 1 to 7, **characterised in that** the at least one insulating implant (125) is provided on one side or both sides with elements of the copper layer (10), such as conductive tracks or thermal bridges, with which the lost heat of the electronic component (200A; 200B, 200C) arranged on the insulating implant (125) is transferable to the metal substrate (12).

9. Insulated metal substrate (1) according to one of the claims 1 to 8, **characterised in that** the at least one metal implant (124) and/or the at least one insulating implant (125) comprises an opening, through which an electrical conductor (10) is guided that optionally is isolated.

10. Insulated metal substrate (1) according to one of the claims 1 to 9, **characterised in that** the at least one metal implant (124) and/or the at least one insulating implant (125) on one side or on both sides is partially overlapped by the insulation layer, preferably in the form of a frame.

## Revendications

1. Substrat métallique isolé (1) avec un substrat métallique (12) sur la face supérieure duquel est disposée une couche d'isolation (11) avec des pistes électriques (10) auxquelles est raccordé ou raccordable un composant électrique (2, 20, 200), **caractérisé en ce que** le substrat métallique (12) est muni au moins d'un évidement (120) danslequel est introduit un implant métallique (124, 125) dont les dimensions correspondent au moins approximativement à celles de l'évidement (120) et qui sert au moins au montage d'un composant électrique (2, 20, 200) .

2. Substrat métallique isolé (1) selon la revendication 1, **caractérisé en ce que** l'implant (124) métallique, éventuellement muni d'une cavité (121), est réalisé, découpé, érodé à partir d'un corps ou au moyen d'un outil et est introduit dans l'évidement (120) et se compose d'un matériau qui présente des coefficients de dilatation similaires aux matériaux céramiques comme A1203, BeO, AlN, ALSiC12.

3. Substrat métallique isolé (1) selon la revendication 2, **caractérisé en ce que** l'implant (124) métallique éventuellement muni d'une couche de métal précieux se compose de cuivre ou d'un alliage, en particulier d'un alliage Invar qui présente dans la plage des températures de service un coefficient de dilatation compris entre 5 ppm/K et 12 ppm/K tels que les alliages ferreux, FeNi, FePt, FePd, FeMn, CoMn, FeNiPt, FeNiMn, CoMnFe ou les alliages de cuivre WCu, MoCu.

4. Substrat métallique isolé (1) selon la revendication 1, 2 ou 3, **caractérisé en ce qu'**au moins un implant isolé (125) se compose de matériau de circuit imprimé tel que du matériau renforcé aux fibres avec une résine réactive au phénol, ou Epoxy telle que FR-2, F3 ou FR4 et est introduit, éventuellement est collé dans l'évidement.

5. Substrat métallique isolé (1) selon l'une des revendications 1 à 4, **caractérisé en ce qu'**au moins un implant isolé (125) n'est pas recouvert par la couche d'isolation (11) et de préférence s'engage dans cette dernière de sorte que l'implant isolé (125) et la couche d'isolation (11) forment une surface pratiquement plane.

6. Substrat métallique isolé (1) selon l'une des revendications 1 à 5, **caractérisé en ce que** sur au moins un implant métallique (124), il est monté au moins un composant électrique ou électronique discret ou intégré (2), tel que des diodes lumineuses ou une puce DEL, qui présente une puissance de perte élevée et/ou **en ce que** sur au moins un implant isolé (125), il est disposé d'un côté ou des deux côtés un composant électronique discret ou intégré, tel qu'un circuit intégré (200A; 200B, 200C) et/ou un contact de connexion (20).

7. Substrat métallique isolé (1) selon l'une des revendications 1 à 6, **caractérisé en ce que** l'implant métallique (124) et/ou l'implant isolé (125) sont préparés avant l'insertion dans le substrat métallique (12) en particulier sont dotés d'une forme souhaitée et/ou prééquipés.

8. Substrat métallique isolé (1) selon l'une des revendications 1 à 7, **caractérisé en ce qu'**au moins un implant isolé (125) est muni, d'un côté ou des deux côtés. d'éléments de la couche de cuivre (10) tels que des pistes conductrices ou des ponts thermiques au moyen desquels la chaleur résiduelle du composant électronique (200A; 200B, 200C) prévu sur l'implant isolé (125) est transmissible au substrat métallique (12).

9. Substrat métallique isolé (1) selon l'une des revendications 1 à 8, **caractérisé en ce qu'**au moins l'implant métallique (124) et/ou l'implant isolé (125) présente une ouverture à travers laquelle est guidé un conducteur électrique (10) éventuellement isolé.

10. Substrat métallique isolé (1) selon l'une des revendications 1 à 9, **caractérisé en ce qu'**au moins l'implant métallique (124) et/ou au moins un implant isolé (125) est recouvert d'un côté ou des deux côtés partiellement de la couche d'isolation, de préférence sous forme de cadre.
